# FASCICULE DE BREVET EUROPEEN

(11) **EP 1 654 773 B1**
(45) Date de publication et mention de la délivrance du brevet: **09.10.2019**
(21) Numéro de dépôt: 04764043.8
(22) Date de dépôt: 12.08.2004
(51) Int. Cl.: H01L 51/52

(54) **PANNEAU ELECTROLUMINESCENT DOTE D'ELEMENTS D'EXTRACTION DE LUMIERE**
ELEKTROLUMINESZENTE TAFEL MIT LICHTEXTRAKTIONSELEMENTEN
ELECTROLUMINESCENT PANEL PROVIDED WITH LIGHT EXTRACTION ELEMENTS

(30) Priorité: 14.08.2003 FR 0309970
(43) Date de publication de la demande: 10.05.2006
(73) Titulaire: InterDigital CE Patent Holdings, 75017 Paris (FR)
(72) Inventeur: FERY, Christophe, 35000 Rennes (FR); DRAZIC, Valter, 35830 Betton (FR)
(74) Mandataire: Tarquis-Guillou, Anne
(86) Numéro de dépôt international: PCT/EP2004/009039
(87) Numéro de publication internationale: WO 2005/022659

(56) Documents cités:
- WO-A-02/15292
- WO-A-03/017385
- WO-A1-2015/140372
- JP-A- 2001 085 738
- JP-A- 2002 151 274
- US-A- 5 087 949
- US-A1- 2001 035 713
- US-A1- 2002 000 772
- US-A1- 2002 101 152
- US-A1- 2002 122 642
- US-A1- 2003 011 303
- US-B1- 6 229 160
- US-B1- 6 320 633
- PATENT ABSTRACTS OF JAPAN vol. 1998, no. 13, 30 novembre 1998 (1998-11-30) -& JP 10 223367 A (MITSUBISHI CHEM CORP), 21 août 1998 (1998-08-21)

## Description

L'invention concerne un panneau d'éclairage ou de visualisation d'images comprenant une matrice mono- ou bi-dimensionnelle de cellules électroluminescentes organiques (« OLED ») dotée de moyens pour faciliter l'extraction de la lumière émise par ces cellules, qui en améliorent sensiblement le rendement lumineux.

Un tel panneau comprend généralement un substrat supportant une couche mince organique électroluminescente partitionnée en cellules électroluminescentes et intercalée entre au moins deux réseaux d'électrodes, l'un d'anodes, l'autre de cathodes, destinées à alimenter chacune des cellules. Un tel panneau comprend également une couche d'encapsulation appliquée sur l'une des couches d'électrodes à l'opposé du substrat, qui est destiné à sceller hermétiquement les cellules de manière à protéger la couche électroluminescente contre les risques de détérioration, notamment sous l'effet de l'oxygène ou de la vapeur d'eau de l'air ambiant.

Ce substrat est généralement à base de verre ; il peut être en matière plastique ; l'épaisseur du substrat est généralement comprise entre 300 µm et 1500 µm, soit 500 à 100 fois supérieure à celle de la couche organique électroluminescente ; le côté ou le diamètre des cellules (pixels ou sous-pixels) est généralement compris entre 100 µm et 300 µm, soit 1 à 15 fois moins que l'épaisseur du substrat.

La couche d'électrodes intercalée entre le substrat et la couche électroluminescente, qui peut comprendre plusieurs réseaux d'électrodes, est généralement appelée « couche inférieure », car, dans les procédés classiques de fabrication, elle est appliquée avant la couche électroluminescente ; l'autre couche d'électrodes, appliquée après et « au dessus » de la couche électroluminescente, est appelée « couche supérieure ».

Selon les cas, la lumière émise par la couche électroluminescente doit traverser le substrat et donc la couche inférieure d'électrodes pour parvenir à l'observateur des images à visualiser (cas des panneaux dits « à émission vers le bas »), ou au contraire traverse la couche supérieure d'électrodes (sans donc traverser le substrat - cas des panneaux dits « à émission vers le haut ») ; dans les deux cas, la lumière émise par la couche électroluminescente doit traverser l'une des couches d'électrodes, l'autre couche d'électrodes étant alors généralement opaque.

La couche d'électrodes qui est transparente est généralement à base de « ITO » et, compte tenu des propriétés électroniques de l'ITO, sert généralement d'anode aux cellules ; l'autre couche d'électrodes qui est opaque est généralement métallique et sert alors de cathode aux cellules ; cette dernière couche peut être réflective, pour récupérer la lumière des cellules émise dans la direction opposée à celle de l'observateur.

Chaque cellule du panneau émet donc de la lumière vers l'extérieur au travers d'une « fenêtre » comprenant une zone transparente de couche d'électrodes, et, le cas échéant, une zone transparente du substrat.

Les différentes couches émissives ou transparentes présentent généralement des indices de réfraction élevés : 1,6 à 1,7 pour la couche électroluminescente, 1,6 à 2 pour la couche d'électrodes en ITO, et, dans le cas où la lumière émise traverse le substrat, de l'ordre de 1,5 si ce substrat est en verre ; la différence importante d'indice entre ces couches et l'air (indice = 1) où se trouve l'observateur limite considérablement le taux d'extraction de la lumière émise par la couche électroluminescente, ce qui limite le rendement lumineux du panneau ; en effet, tout rayon parvenant à l'un des dioptres d'interfaces entre ces couches (ou entre la dernière couche et l'air) sous une incidence supérieure à l'angle limite de réfraction sur cet interface (ou angle de réflexion totale) est totalement réfléchi et piégé au sein du panneau et généralement perdu. En l'absence de système additionnel d'extraction tel que décrit ci-dessous, le rendement d'extraction est généralement de l'ordre de 0,19 dans le cas favorable où la couche opaque d'électrodes est réflective.

Pour améliorer l'extraction de lumière, les documents US6091384 - PIONEER - et US6229160 - LUMILEDS LIGHTING - proposent des systèmes d'extraction par réflexion : on accole à la fenêtre d'émission de chaque cellule un barreau transparent d'extraction de lumière ; d'autres documents proposent des systèmes d'extraction par réfraction basés sur des lentilles (une lentille par cellule), voire sur des micro-lentilles (une pluralité de lentilles par cellule) comme JP2001-117499.

Selon les documents précités concernant les barreaux d'extraction de lumière, chacun de ces barreaux d'extraction est en matériau transparent et forme un canal de lumière qui comprend une section transparente d'entrée accolée à la fenêtre d'émission d'une cellule, une section transparente de sortie orientée vers l'extérieur du panneau, et, entre ces sections, des parois latérales réfléchissantes.

L'indice du matériau de ces barreaux d'extraction est adapté pour que la plus grande partie de la lumière émise au sein de la couche électroluminescente pénètre dans ces barreaux ; chaque barreau forme donc un canal d'extraction de lumière pour la cellule qui lui correspond.

La forme de la section d'entrée de ces barreaux est adaptée à la forme des fenêtres d'émission des cellules.

La forme de la section de sortie de ces barreaux, la longueur de ces barreaux, et la forme de leurs parois latérales sont adaptées pour que la plus grande partie de la lumière qui rentre par la section d'entrée d'un barreau en sorte par la section de sortie après réflexion sur les parois latérales de ce barreau.

Les parois latérales de ces barreaux peuvent être opaques réfléchissantes ou transparentes ; on obtient des parois opaques réfléchissantes par exemple par métallisation ; lorsqu'elles sont transparentes, il importe que le dioptre formé par ces parois offre un angle limite de réfraction le plus élevé possible pour réfléchir la plus grande partie des rayons qui le frappe et permettre l'extraction des rayons par la section de sortie.

La fonction des parois latérales de chaque barreau est de modifier, par réflexion, la direction des rayons lumineux qui les frappent de manière à diminuer l'angle d'incidence de ces rayons sur la section de sortie de ce barreau, en deçà de la valeur de l'angle limite de réfraction au travers de cette section de sortie.

En pratique, les barreaux d'extraction de lumière sont généralement accolés les uns aux autres et forment une couche d'extraction qui est appliquée sur le substrat, du côté opposé à la couche électroluminescente, dans le cas de panneaux à émission vers le bas, ou qui est appliquée sur la couche supérieure d'électrodes transparentes dans le cas des panneaux à émission vers le haut.

L'épaisseur de la couche d'extraction dépend de la surface de la fenêtre d'émission de chaque cellule ; elle est généralement supérieure à celle du substrat ; cette couche est donc relativement épaisse, ce qui alourdit le panneau ; une telle couche n'est pas envisageable pour des panneaux souples.

Lors de l'application d'une telle couche, se posent des problèmes d'alignement : en effet, il convient de la positionner de manière à ce qui la section d'entrée de chaque barreau coïncide avec la fenêtre d'émission d'une cellule. Ces contraintes de positionnement sont pénalisantes pour la fabrication des panneaux.

Les documents US 2001/035713, US2002/122642, JP 2002 151274 et JP 2001 085738 divulguent des panneaux électroluminescents comportant une couche d'extracteurs de lumière.

Un but de l'invention est d'éviter les inconvénients précités.

A cet effet, l'invention a pour objet un panneau d'éclairage ou de visualisation d'images selon la revendication 1.

Dans un tel panneau, chaque cellule correspond à une zone de recouvrement d'une électrode de chaque couche. Chaque cellule est susceptible d'émettre de la lumière vers l'extérieur du panneau au travers d'une fenêtre d'émission, qui comprend, en amont de la couche d'extracteurs, une zone transparente de la couche transparente d'électrodes et, le cas échéant, une zone transparente du substrat ; c'est via ces zones transparentes superposées que s'effectue le couplage optique de la couche électroluminescente aux pluralités d'extracteurs.

Selon l'invention, la fenêtre d'émission de chaque cellule comprend alors une pluralité d'extracteurs, de sorte que la lumière émise par cette cellule est distribuée à cette pluralité d'extracteurs via leur section d'entrée avant de sortir du panneau par leur section de sortie. Grâce à cette répartition de la lumière de chaque cellule sur plusieurs extracteurs selon l'invention, on peut diminuer sensiblement l'épaisseur de la couche d'extraction sans diminuer les performances d'extraction de cette couche. Le couplage optique de la section d'entrée des extracteurs avec la couche électroluminescente se fait donc via la couche transparente d'électrodes, et non pas par la tranche comme dans le document US6320633.

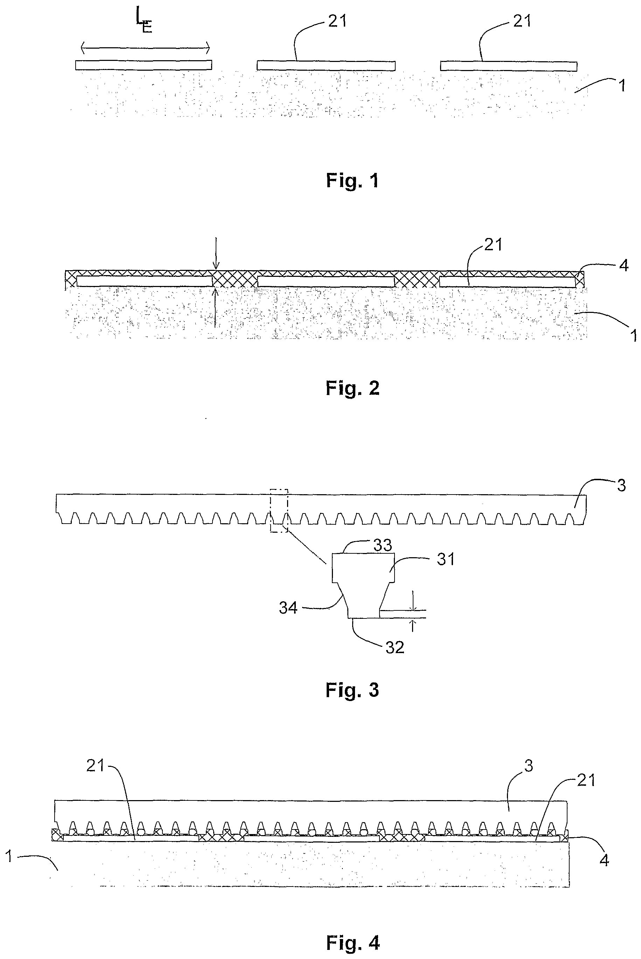

La zone de recouvrement d'une électrode de chaque couche peut être partitionnée, comme illustré aux figures 3 et 4B, 22 et 23 du document US2002/101152, de sorte qu'une seule et même cellule ou diode électroluminescente comprend plusieurs zones émissives plus ou moins disjointes. A remarquer d'ailleurs que les parois latérales des extracteurs associés à une même cellule et illustrés notamment à ces mêmes figures 3 et 4B, 22 et 23 ne forment pas toutes des surfaces fermées (cas des deux zones émissives supérieures de ces figures), contrairement à l'invention.

Chaque extracteur comprend donc un barreau en matière transparente, dont les extrémités forment les sections d'entrée et de sortie de lumière, et dont les parois forment une surface réfléchissante fermée, c'est à dire un canal « étanche » de lumière ; on entend par surface fermée, une surface dont toute section parallèle à la section d'entrée ou de sortie forme une courbe fermée, comme un carré ou un cercle ; ces sections peuvent être de forme quelconque : forme générale carrée ou circulaire par exemple. La forme de cette surface réfléchissante peut être notamment conique.

La couche transparente d'électrodes n'est pas forcément intégralement transparente ; elle peut comporter par exemple des grilles de conducteurs opaques intercalées entre les fenêtres d'émission des cellules.

Dans le cas de panneau à émission vers le bas, le substrat, qui est donc transparent, n'est pas forcément intégralement transparent ; dans le cas, par exemple, de panneaux à matrice active, ce substrat intègre des circuits électroniques de pilotage des cellules qui sont disposés entre les fenêtres d'émission des cellules, comme par exemple dans le document US2002/101152.

De préférence, la couche opaque d'électrodes est réfléchissante, ce qui permet de réorienter dans les fenêtres d'émission des cellules une partie importante de la lumière de la couche électroluminescente qui est émise en direction opposée à celle de la sortie du panneau ; ceci permet d'améliorer le rendement lumineux du panneau.

La couche d'extracteurs est directement appliquée sur la couche transparente d'électrodes, via une couche de colle transparente d'épaisseur largement inférieure à celle de la couche d'extracteurs, typiquement de l'ordre de 2 à 3 µm.

Selon cette disposition de l'invention, en aucun cas le substrat ne se trouve donc intercalé entre la couche d'extracteurs et la couche transparente d'électrodes ; la distance entre la couche émettrice électroluminescente et les sections d'entrée des extracteurs est donc très faible, selon l'invention inférieure ou égale à 2 µm, ce qui améliore encore l'extraction de lumière en présence de la couche d'électrodes réfléchissantes à l'arrière de la couche électroluminescente, ce qui permet d'améliorer encore le rendement lumineux.

De préférence, ladite pluralité d'extracteurs comprend plus de cent extracteurs. Cette densité élevée d'extracteurs apporte notamment deux avantages importants :
- elle permet de diminuer fortement l'épaisseur de la couche d'extraction, et d'alléger d'autant le panneau.
- elle permet de diminuer très significativement les contraintes d'alignement des extracteurs avec les cellules, au moment de l'application de la couche d'extraction pendant la fabrication du panneau.

Si la dimension des fenêtres d'émission des cellules est de 100 µm x 300 µm au niveau de l'entrée de la couche d'extraction, si l'on dispose alors six extracteurs sur la largeur et dix-huit sur la longueur, on obtient alors un réseau de 108 extracteurs par cellule. Pour chaque cellule, chaque fenêtre d'émission de cellule passe donc par au moins par plus de cent extracteurs.

De préférence, la couche d'extraction sert de couche d'encapsulation, ou fait partie de la couche d'encapsulation (dans le cas où cette dernière est « multicouche ») ; il s'agit là d'une disposition avantageuse dans le cas de panneaux à émission vers le haut.

L'invention sera mieux comprise à la lecture de la description qui va suivre, donnée à titre d'exemple non limitatif, et en référence aux figures annexées sur lesquelles :
- les figures 1, 2 et 4 représentent différentes étapes de la fabrication d'un panneau selon l'invention selon un premier mode de réalisation ;
- la figure 3 représente une vue en coupe de la couche d'extraction utilisée pour la fabrication du panneau représentée aux figures 1, 2 et 4.
- la figure 5 est une vue en coupe de trois extracteurs adjacents couplés à la même cellule d'un panneau selon l'invention selon un deuxième mode de réalisation ;
- la figure 6 représente la couche d'extraction de la figure 3 en vue en perspective de dessous.

Afin de simplifier la description et de faire apparaître les différences et avantages que présente l'invention par rapport à l'état antérieur de la technique, on utilise des références identiques pour les éléments qui assurent les mêmes fonctions.

En référence aux figures 1 à 5, on va d'abord décrire une méthode de fabrication d'un panneau électroluminescent de visualisation d'images selon l'invention, ici du type à émission vers le haut.

Sur un substrat en verre 1 par exemple de 0,75 mm d'épaisseur, en utilisant des méthodes classiques telles que décrites dans les documents WO 01/15244 - EMAGIN, US5920080 - FED Co, on dépose successivement une couche d'électrodes métalliques par exemple à base d'aluminium, une couche organique électroluminescente partitionnée, et une couche d'électrodes transparentes à base d'ITO.

La couche d'aluminium est réfléchissante ; la couche électroluminescente comprend d'une manière classique plusieurs sous-couches : outre une sous-couche émettrice électroluminescente à proprement parler, elle comprend notamment une sous-couche d'injection d'électrons au contact de l'électrode servant de cathode et une sous-couche d'injection de trous au contact de l'électrode servant d'anode.

Les partitions de la couche organique électroluminescente forment des cellules 21 à base rectangulaire, par exemple de dimensions 100 µm x 300 µm.

La couche électroluminescente est partitionnée en cellules 21 ; chaque cellule est alimentée entre une cathode et une anode appartenant aux réseaux d'électrodes situés de part et d'autre de la couche électroluminescente ; ces réseaux d'électrodes ne sont pas représentés sur les figures.

Le substrat ainsi doté de cellules électroluminescentes est représenté à la figure 1.

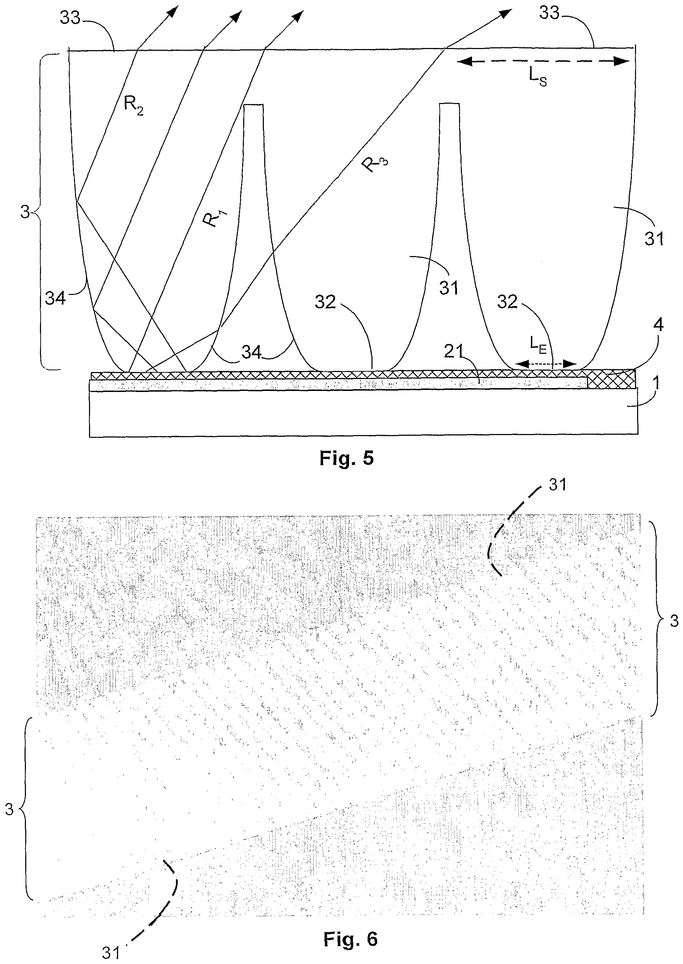

Par ailleurs, on prépare une couche d'extraction 3 telle que représentée à la figure 6 ; typiquement, une telle couche peut être réalisée de manière économique par moulage à chaud d'une feuille en matériau polymère thermoplastique transparent en utilisant un moule d'une forme adaptée pour former dans la feuille des extracteurs 31 en forme de polyèdres ; chaque polyèdre comprend ici une section carrée d'entrée de lumière 32, une section carrée de sortie de lumière 33, et quatre parois latérales planes 34 en forme de trapèze.

Pour la section rectangulaire d'entrée 32 des extracteurs, on choisit, selon l'invention, des dimensions beaucoup petites que celles de la base des cellules.

On peut choisir par exemple les dimensions suivantes :
- côté L_{E} d'une section d'entrée : 3 µm ;
- côté L_{S} d'une section de sortie : 4 µm ;
- épaisseur de couche d'extraction = hauteur de chaque extracteur : 3 µm.
- pas entre deux extracteurs adjacents : 5 µm.

Du fait de la surface plus importante de la section de sortie par rapport à la section d'entrée, chaque extracteur présente une forme évasée ; à l'entrée et ou à la sortie de chaque extracteur, on peut adjoindre des parties cylindriques (donc non évasées).

Une coupe de la couche d'extraction 3 a été représentée à la figure 3 avec une vue agrandie d'un extracteur 31 présentant une partie cylindrique (à section carrée) à l'entrée et ou à la sortie.

Comme expliqué ultérieurement, on choisit comme matériau polymère transparent un matériau d'indice suffisamment élevé pour améliorer le couplage optique des extracteurs avec la couche électroluminescente et pour que les parois latérales de ces extracteurs forment des dioptres essentiellement de réflexion pour la lumière circulant dans ces extracteurs. Comme matériau polymère, on peut utiliser par exemple des polyacryliques comme le PMMA (indice = 1,49), des polycarbonates ou des polystyrènes (indice = 1,58-1,59).

On poursuit maintenant la fabrication du panneau selon l'invention.

Sur les cellules électroluminescentes du substrat tel représenté à la figure 1, on applique une couche de colle 4 transparente ; pour améliorer le couplage optique entre les cellules et les extracteurs, on choisit de préférence une colle d'indice intermédiaire entre celui de la couche d'électrodes transparentes recouvrant les cellules et celui de la couche d'extraction 3 ; l'épaisseur de la couche de colle est généralement comprise entre 1 et 2 µm.

Le substrat ainsi doté de cellules électroluminescentes revêtues d'une couche de colle est représenté à la figure 2.

On applique ensuite la couche d'extraction 3 sur la couche de colle 4, et on la presse contre le substrat de manière les sections d'entrée des extracteurs pénètrent dans la couche de colle comme représenté à la figure 4, ce qui permet avantageusement de diminuer la distance entre les cellules électroluminescentes et les sections d'entrée des extracteurs en dessous de 1 µm, ce qui permet d'améliorer le rendement d'extraction.

Après durcissement de la colle, on obtient alors le panneau selon l'invention ; les sections d'entrée 32 des extracteurs sont optiquement couplées à la couche électroluminescente, et les sections de sortie 33 sont orientées vers l'extérieur du panneau, comme représenté à la figure 4.

On voit que, en moyenne, dans le panneau ainsi obtenu, chaque cellule est dotée de 1200 extracteurs (rapport surface cellule / pas au carré des extracteurs).

Grâce à ce nombre moyen élevé d'extracteurs par cellule, on évite les contraintes d'alignement au moment de l'application de la couche d'extraction 3 sur les cellules 21, et on utilise une couche d'extraction de faible épaisseur - ici, seulement 3 µm, de l'ordre de 4 µm en intégrant la couche de colle - tout en obtenant de très bonnes performances d'extraction - voir ci-après.

Le principe de fonctionnement des extracteurs est représenté à la figure 5 qui illustre une coupe d'une portion du panneau selon l'invention comprenant trois extracteurs adjacents 31, dont les sections d'entrée 32, de côté L_{E}, sont optiquement couplées à la même cellule 21, via une couche de colle 4.

Dans l'exemple représenté sur la figure, les parois latérales des extracteurs sont courbes, contrairement à l'exemple présenté à la figure 3, mais le principe de fonctionnement des extracteurs est identique dans les deux cas.

Pour tout rayon émergeant de la cellule 21 et rentrant dans l'un des extracteurs 31, plusieurs cas peuvent se présenter :
- cas du rayon R₁ : il traverse directement l'extracteur 31 sans réflexion ni réfraction intermédiaire, jusqu'à la section de sortie 33 où il est réfracté vers l'extérieur du panneau.
- cas du rayon R₂ : il frappe l'une des parois latérales 34 de l'extracteur 31 selon un angle d'incidence supérieur à l'angle limite de réfraction ; il est donc réfléchi en direction de la section de sortie 33 où il est réfracté vers l'extérieur du panneau.
- cas du rayon R₃ : il frappe l'une des parois latérales 34 de l'extracteur 31 selon un angle d'incidence inférieur à l'angle limite de réfraction ; il traverse donc cette paroi qui est transparente jusqu'à un extracteur adjacent dans lequel il pénètre après une deuxième réfraction, puis traverse directement ce deuxième extracteur sans réflexion ni réfraction intermédiaire, jusqu'à la section de sortie 33 de ce deuxième extracteur, où il est réfracté vers l'extérieur du panneau.

Il y a aussi des rayons qui ne frappent pas la couche d'extraction à l'endroit de la base ou de la section d'entrée d'un extracteur ; soit ces rayons présentent un angle d'incidence en cet endroit tel qu'ils ne sont pas totalement refléchis par cette couche mais y pénètrent et en sortent d'une manière ou d'une autre, un peu comme le rayon R₃ ci-dessus ; soit ces rayons sont plus inclinés en cet endroit, sont alors réfléchis par la couche d'extraction vers l'intérieur du panneau, où ils sont recyclés par réflexion sur la couche d'électrodes réfléchissante en aluminium (cathodes).

D'autres cheminements de rayons lumineux émis par la cellule 21 sont évidemment possibles vers l'extérieur du panneau.

A noter que l'angle limite de réflexion totale entre la couche d'électrodes transparentes (anodes) et la couche d'extracteurs est très grand parce que la différence d'indice entre ces couches est, en pratique, faible : la plupart des rayons émis par la couche électroluminescente traversent donc cet interface. Le recyclage par réflexion sur cet interface reste donc relativement faible par rapport au recyclage précédemment décrit.

En utilisant la couche d'extraction spécifique qui vient d'être décrite - voir les dimensions des extracteurs ci-dessus, on a obtenu un gain de 80% de lumière émise par le panneau par comparaison avec le même panneau sans couche d'extraction : grâce à l'invention, on parvient à dépasser 30% de taux de lumière extraite, contre 19% environ sans couche d'extraction.

Selon une variante du mode de réalisation qui vient d'être décrit, la couche d'extraction sert de couche d'encapsulation pour sceller les cellules du panneau et protéger la couche électroluminescente contre l'oxygène et l'humidité ; le matériau polymère transparent de cette couche est alors choisi en conséquence d'une manière connue en elle-même.

Sans se départir de l'invention, on peut utiliser d'autres formes d'extracteurs que celle précédemment décrite, notamment des polyèdres à base rectangulaire (les sections d'entrée et de sortie sont rectangulaires), des troncs de cône (les sections d'entrée et de sortie sont circulaires), des extracteurs dont les parois latérales sont courbes.

La présente invention a été décrite en se référant à un panneau OLED de type à émission vers le haut ; il est évident pour l'homme du l'art qu'elle peut s'appliquer à d'autres types de panneaux sans sortir du cadre des revendications ci-après, et notamment aux panneaux à émission vers le bas, auquel cas la couche d'extraction est intercalée entre le substrat et la couche électroluminescente.

## Revendications

1. Panneau d'éclairage ou de visualisation d'images comprenant un substrat (1) supportant :
- une couche organique électroluminescente partitionnée en cellules électroluminescentes (21) et intercalée entre deux couches d'électrodes dont l'une est transparente, l'autre opaque, chaque cellule correspondant à une zone de recouvrement d'une électrode de chaque couche,
- une couche (3) d'extracteurs de lumière, en matériau transparent, procédant par réflexion et comprenant une section d'entrée de lumière (32), une section de sortie de lumière (33) orientée vers l'extérieur du panneau, et des parois latérales (34) formant des dioptres de réflexion pour la lumière circulant dans les extracteurs et une surface réfléchissante fermée, la surface de ladite section de sortie (33) d'un extracteur étant supérieure à la surface de ladite section d'entrée (32) de l'extracteur,
où la zone de couche électroluminescente de chaque cellule (21) est optiquement couplée à une pluralité d'extracteurs (31),
**caractérisé en ce que** les sections d'entrées de lumière des extracteurs sont optiquement couplées à la couche électroluminescente via ladite couche transparente d'électrodes et via une couche de colle durcie (4), ladite couche de colle durcie étant au moins présente entre la couche transparente d'électrodes et la couche d'extracteurs de lumière, les sections d'entrée des extracteurs pénétrant dans ladite couche de colle durcie;
et **en ce que** la distance entre la couche électroluminescente et les sections d'entrée des extracteurs est inférieure ou égale à 2 µm.

2. Panneau selon la revendication 1 **caractérisé en ce que** ladite pluralité d'extracteurs associée à une cellule dans ledit panneau comprend plus de cent extracteurs (31).

3. Panneau selon la revendication 1 ou 2 **caractérisé en ce que** ladite pluralité d'extracteurs associée à une cellule dans ledit panneau comprend en moyenne 1200 extracteurs (31).

4. Panneau selon l'une quelconque des revendications précédentes **caractérisé en ce que** ladite couche d'électrodes transparente est positionnée au-dessus de ladite couche organique électroluminescente à l'opposé du substrat.

5. Panneau selon la revendication 4 **caractérisé en ce que** :
- ledit panneau comprend une couche d'encapsulation positionnée au dessus de ladite couche transparente d'électrodes,
- ladite couche d'extraction fait partie de ladite couche d'encapsulation.

6. Panneau selon l'une quelconque des revendications précédentes **caractérisé en ce que** la couche opaque d'électrodes est réfléchissante.

## Patentansprüche

1. Tafel zur Beleuchtung oder zur Visualisierung von Bildern, die ein Substrat (1) umfasst, das aufweist:
- eine elektrolumineszierende organische Schicht, aufgeteilt in elektrolumineszierende Zellen (21) und angeordnet zwischen zwei Elektrodenschichten, von denen die eine transparent und die andere lichtundurchlässig ist, wobei jede Zelle einem Überlappungsbereich einer Elektrode von jeder Schicht entspricht,
- eine Schicht (3) von Lichtextraktoren, aus transparentem Material, mittels Reflexion vorgehend und umfassend einen Lichteintrittsabschnitt (32), einen zur Außenseite der Tafel gerichteten Lichtaustrittsabschnitt (33), und Seitenwände (34), die Reflexionsdiopter für das in den Extraktoren zirkulierende Licht bilden, und eine geschlossene reflektierende Oberfläche, wobei die Oberfläche des besagten Austrittsabschnitts (33) eines Extraktors größer als die Oberfläche des besagten Eintrittsabschnitts (32) des Extraktors ist,
wo der Bereich von elektrolumineszierender Schicht von jeder Zelle (21) optisch mit einer Vielzahl von Extraktoren (31) gekoppelt ist,
**dadurch gekennzeichnet, dass** die Lichteintrittsabschnitte der Extraktoren optisch mit der elektrolumineszierenden Schicht über die besagte transparente Elektrodenschicht und über eine ausgehärtete Klebeschicht (4) gekoppelt sind, wobei die besagte ausgehärtete Klebeschicht mindestens zwischen der transparenten Elektrodenschicht und der Schicht von Lichtextraktoren vorhanden ist, wobei die Eintrittsabschnitte der Extraktoren in die besagte ausgehärtete Klebeschicht eindringen;
und dadurch, dass der Abstand zwischen der elektrolumineszierenden Schicht und den Eintrittsabschnitten der Extraktoren weniger oder gleich 2 µm ist.

2. Tafel nach Anspruch 1, **dadurch gekennzeichnet, dass** die mit einer Zelle in der besagten Tafel verbundene Vielzahl von Extraktoren über einhundert Extraktoren (31) umfasst.

3. Tafel nach Anspruch 1 oder 2, **dadurch gekennzeichnet, dass** die mit einer Zelle in der besagten Tafel verbundene Vielzahl von Extraktoren durchschnittlich 1.200 Extraktoren (31) umfasst.

4. Tafel nach einem der vorstehenden Ansprüche, **dadurch gekennzeichnet, dass** die besagte transparente Elektrodenschicht über der besagten elektrolumineszierenden organischen Schicht gegenüber dem Substrat positioniert ist.

5. Tafel nach Anspruch 4, **dadurch gekennzeichnet, dass**:
- die besagte Tafel eine Verkapselungsschicht aufweist, die über der besagten transparenten Elektrodenschicht positioniert ist,
die Extraktionsschicht Bestandteil der besagten Verkapselungsschicht ist.

6. Tafel nach einem der vorstehenden Ansprüche, **dadurch gekennzeichnet, dass** die lichtundurchlässige Elektrodenschicht reflektierend ist.

## Claims

1. Image lighting or display panel comprising a substrate (1) supporting:
- a light emitting organic layer partitioned in light emitting cells (21) and sandwiched between two layers of electrodes, one of which is transparent, the other opaque, each cell corresponding to a cover zone of an electrode of each layer,
- a layer (3) of light extractors, made up of a transparent material, operating by reflection and comprising a light inlet section (32), a light outlet section (33) positioned towards the outside of the panel, and side walls (34) forming reflective diopters for light circulating inside the extractors and a closed reflective surface, the surface of said outlet section (33) of an extractor being superior to the surface of said inlet section (32) of the extractor,
Where the light emitting layer zone of each cell (21) is optically coupled to a plurality of extractors (31),
**Characterised in that** the light inlet sections of the extractors are optically coupled to the light emitting layer via said transparent layer of electrodes and via a layer of hardened glue (4), said layer of hardened glue being at least present between the transparent layer of electrodes and the layer of light extractors, the inlet sections of the extractors penetrating in said layer of hardened glue;
And **in that** the distance between the light emitting layer and the inlet sections of the extractors are inferior or equal to 2 µm.

2. Panel according to claim 1, **characterised in that** said plurality of extractors associated with a cell in said panel comprises more than one hundred extractors (31).

3. Panel according to claim 1 or 2, **characterised in that** said plurality of extractors associated to a cell in said panel comprises on average 1200 extractors (31).

4. Panel according to any one of the preceding claims, **characterised in that** said layer of transparent electrodes is positioned above the said light emitting organic layer opposite the substrate.

5. Panel according to claim 4, **characterised in that**
- said panel comprises an encapsulation layer positioned above said transparent layer of electrodes,
- said extraction layer is part of said encapsulation layer.

6. Panel according to any one of the preceding claims, **characterised in that** the opaque layer of electrodes is reflective.
